# EUROPÄISCHE PATENTANMELDUNG

(11) **EP 0 783 181 A1**
(43) Veröffentlichungstag der Anmeldung: **09.07.1997**
(21) Anmeldenummer: 96120099.5
(22) Anmeldetag: 13.12.1996
(51) Int. Cl.: H01L 27/115, H01L 21/8247

(54) **Elektrisch programmierbare Speicherzellenanordnung und Verfahren zu deren Herstellung**

(30) Priorität: 08.01.1996 DE 19600423
(71) Anmelder: SIEMENS AKTIENGESELLSCHAFT, 80333 München (DE)
(72) Erfinder: Hofmann, Franz, Dr., 80995 München (DE); Willer, Josef, Dr., 85521 Riemerling (DE); Krautschneider, Wolfgang, Dr., 83104 Hohenthann (DE); Reisinger, Hans, Dr., 82031 Grünwald (DE)

(57) **Zusammenfassung**

Eine elektrisch programmierbaren Speicherzellenanordnung enthält Speicherzellen, die einen vertikalen MOS-Transistor mit einem Gatedielektrikum (17) aus einem Material mit Haftstellen umfassen. Vorzugsweise sind die Speicherzellen entlang gegenüberliegenden Flanken von streifenförmigen, parallel verlaufenden Isolationsgräben (12) angeordnet. Breite und Abstand der Isolationsgräben (12) sind vorzugsweise gleich, so daß die Speicherzellenanordnung mit einem Platzbedarf pro Speicherzelle von 2F² realisierbar ist, wobei F die minimale Strukturgröße in der jeweiligen Technologie ist. Durch Injektion von Elektronen in das Gatedielektrikum (17) sind die Speicherzellen einmal programmierbar.

## Beschreibung

Für viele elektronische Systeme werden Speicher benötigt, in die Daten in digitaler Form einmal fest eingeschrieben werden können. Derartige Speicher werden unter anderem als OTP-Memory bezeichnet.

Für große Datenmengen, wie insbesondere die digitale Abspeicherung von Musik oder Photos, werden als Speicher vielfach Kunststoffscheiben, sogenannte Compact Discs, verwendet, die mit Aluminium beschichtet sind. In der Beschichtung weisen diese Scheiben zweierlei punktartige Vertiefungen auf, die den logischen Werten Null und Eins zugeordnet werden. In der Anordnung dieser Vertiefungen ist die Information digital abgespeichert. Die Vertiefungen werden z. B. mithilfe eines Lasers erzeugt. Dadurch sind die Compact Discs einmal beschreibbar.

Zum Schreiben oder Lesen einer Compact Disc wird die Scheibe in einem Schreib-/Lesegerät mechanisch rotiert. Die punktartigen Vertiefungen werden beim Lesen der Information über eine Laserdiode und eine Photozelle abgetastet. Typische Abtastraten sind dabei 2 x 40 kHz. Zum Schreiben der Information wird die Laserdiode mit höherer Energie betrieben, wobei in der absorbierenden Schicht der Compact Disc einen Änderung erfolgt, die eine Vertiefung bildet. Auf einer Kunststoffscheibe können ca. 5 Gbit-Informationen gespeichert werden.

Das Schreib-/Lesegerät umfaßt bewegte Teile, die mechanisch verschleißen, die vergleichsweise viel Volumen benötigen, die nur einen langsamen Datenzugriff erlauben und großen Stromverbrauch aufweisen. Darüber hinaus ist das Schreib-/Lesegerät empfindlich gegen Erschütterungen und daher für mobile Systeme nur begrenzt geeignet.

Zur Speicherung kleinerer Datenmengen werden vielfach elektrisch programmierbare Speicher auf Halbleiterbasis, sogenannte EEPROM oder Flash Memory, insbesondere aus Silizium, verwendet. In elektrisch programmierbaren Speicherzellenanordnungen wird die Speicherung der Information meist dadurch bewirkt, daß zwischen dem Gate und dem Kanalgebiet der MOS-Transistoren ein floatendes Gate, das mit einer elektrischen Ladung beaufschlagt werden kann, oder als Gatedielektrikum eine Doppelschicht aus SiO₂ und Si₃N₄, an deren Grenzfläche elektrische Ladungsträger an Haftstellen festgehalten werden können, vorgesehen ist. Die Einsatzspannung des MOS-Transistors ist abhängig von der auf dem floatenden Gate bzw. den Haftstellen befindlichen Ladung. Diese Eigenschaft wird zur elektrischen Programmierung ausgenutzt (siehe zum Beispiel S. M. Sze, Semiconductor Devices, John Wiley, Seite 486 bis 490).

Beim Auslesen der Speicherzellenanordnung werden die einzelnen Speicherzellen über eine Wortleitung ausgewählt. Die Gateelektrode der MOS-Transistoren ist jeweils mit einer Wortleitung verbunden. Der Eingang jedes MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden die logischen Werte Null und Eins zugeordnet.

Technisch wird die Speicherung von Null und Eins bei diesen Speichern dadurch bewirkt, daß die MOS-Transistoren je nach eingespeicherter Information unterschiedliche Einsatzspannungen aufweisen.

Diese bekannten Siliziumspeicher weisen meist einen planaren Aufbau auf. Damit wird pro Speicherzelle ein minimaler Flächenbedarf erforderlich, der bei etwa 6 bis 8 F² liegt, wobei F die in der jeweiligen Technologie kleinste herstellbare Strukturgröße ist. Planare Festwertsiliziumspeicher sind damit bei einer 0,4 µm-Technologie auf Speicherdichten um 1 Bit/µm² begrenzt.

Der Erfindung liegt das Problem zugrunde, eine elektrisch programmierbare Speicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzellenanordnung angegeben werden.

Das Problem wird erfindungsgemäß gelöst durch eine Speicherzellenanordnung gemäß Anspruch 1 sowie ein Verfahren zu deren Herstellung gemäß Anspruch 8. Weitere Ausgestaltungen der Erfindung ergeben sich aus den Unteransprüchen.

In der erfindungsgemäßen Speicherzellenanordnung ist in einem Halbleitersubstrat, vorzugsweise aus monokristallinem Silizium oder in einer Siliziumschicht eines SOI-Substrates, ein Zellenfeld mit Speicherzellen vorgesehen. Die Speicherzellen umfassen einen zur Hauptfläche des Halbleitersubstrates vertikalen MOS-Transistor, der ein Gatedielektrikum aus einem Material mit Haftstellen aufweist. Haftstellen, englisch traps, haben die Eigenschaften, Ladungsträger, speziell Elektronen, einzufangen. Zur elektrischen Programmierung werden die MOS-Transistoren so beschaltet, daß der zu speichernden Information entsprechende Ladungsträger in das Gatedielektrikum gelangen und von den Haftstellen festgehalten werden.

Die Programmierung der Speichzellenanordnung erfolgt nach der Herstellung durch Injektion von Elektronen. Dieses kann sowohl durch Fowler-Nordheim-Tunneln als auch durch Hot-Electron-Injection erfolgen.

Durch Umkehr der Polaritäten beim Fowler-Nordheim-Tunneln können Ladungsträger aus den Haftstellen entfernt werden, so daß die Programmierung der Speicherzellenanordnung geändert wird.

Zur Abspeicherung von Daten in digitaler Form werden die MOS-Transistoren so programmiert, daß sie zwei unterschiedliche Schwellenspannungen aufweisen. Soll die Festwert-Speicherzellenanordnung für Mehrwertlogik eingesetzt werden, so wird das Gatedielektrikum durch entsprechende Spannungs- und Zeitbedingungen bei der Programmierung so mit unterschiedlichen Ladungsmengen beaufschlagt, daß die MOS-Transistoren je nach eingespeicherter Information mehr als zwei unterschiedliche Schwellenspannungen aufweisen.

Das Gatedielektrikum ist gemäß einer Ausführungsform der Erfindung als Mehrfachschicht ausgebildet, in der mindestens eine Schicht vorgesehen ist, die im Vergleich mit mindestens einer weiteren Schicht in der Mehrfachschicht einen erhöhten Ladungsträgereinfangquerschnitt aufweist. Die Haftstellen sind an der Grenzfläche zwischen beiden Schichten lokalisiert. Vorzugsweise umfaßt die dielektrische Mehrfachschicht eine SiO₂-Schicht, eine Si₃N₄-Schicht und eine SiO₂-Schicht (sogenanntes ONO). Alternativ kann das Gatedielektrikum als Mehrfachschicht aus anderen Materialien, wobei die Schicht mit dem erhöhten Ladungsträgereinfangquerschnitt zum Beispiel aus Si₃N₄, Ta₂O₅, Al₂O₃ oder aus TiO₂ besteht und die benachbarte Schicht aus SiO₂, Si₃N₄ oder Al₂O₃. Ferner kann die Mehrfachschicht mehr oder weniger als drei Schichten umfassen.

Alternativ kann das Gatedielektrikum eine dielektrische Schicht, zum Beispiel aus SiO₂ umfassen, in die Fremdatome , zum Beispiel W, Pt, Cr, Ni, Pd, Si oder Ir eingelagert sind. Die eingelagerten Fremdatome können durch Implantation, durch Zugabe bei einer Oxidation oder durch Diffusion eingebracht werden. Die eingelagerten Fremdatome bilden in diesem Fall die Haftstellen.

Vorzugsweise sind im Zellenfeld mehrere, im wesentlichen parallel verlaufende, streifenförmige Isolationsgräben vorgesehen. Die Isolationsgräben verlaufen über das gesamte Zellenfeld. Die Speicherzellen sind jeweils an gegenüberliegenden Flanken der Isolationsgräben angeordnet. Dabei überlappt die Fläche der Speicherzellen die jeweilige Flanke.

Am Boden der Isolationsgräben und an der Hauptfläche des Halbleitersubstrats jeweils zwischen benachbarten Isolationsgräben sind streifenförmige, dotierte Gebiete angeordnet, die entgegengesetzt zum Halbleitersubstrat dotiert sind. Die streifenförmigen, dotierten Gebiete verlaufen parallel zu den Isolationsgräben über das gesamte Zellenfeld. Die vertikalen MOS-Transistoren der Speicherzellen werden so realisiert, daß jeweils ein am Boden eines Isolationsgrabens verlaufendes streifenförmiges, dotiertes Gebiet und ein zwischen dem Isolationsgraben und dem benachbarten Isolationsgraben an der Hauptfläche angeordnetes streifenförmiges, dotiertes Gebiet die Source/Drain-Gebiete des MOS-Transistors bilden. Gatedielektrikum und Gatelektrode des MOS-Transistors sind in einem Loch angeordnet, das an die Flanke des Isolationsgrabens angrenzt und sich bis in den Isolationsgraben hinein erstreckt. Dieses Loch ist mit dem Gatedielektrikum und einer Gateelektrode ausgefüllt.

An der Hauptfläche sind Wortleitungen angeordnet, die quer zu den Isolationsgräben verlaufen. Die Wortleitungen sind jeweils mit Gateelektroden von unterhalb der jeweiligen Wortleitung angeordneten vertikalen MOS-Transistoren verbunden.

Die streifenförmigen, dotierten Gebiete, die am Boden der Isolationsgräben und jeweils zwischen benachbarten Isolationsgräben an der Hauptfläche des Halbleitersubstrats angeordnet sind, werden zum Auslesen der Speicherzellen als Bit- bzw. Referenzleitung verwendet. Die zu bewertende Speicherzelle wird über die Wortleitung ausgewählt. Es wird bewertet, ob zwischen den zugehörigen streifenförmigen dotierten Gebieten ein Strom fließt oder nicht.

Vorzugsweise wird der Abstand zwischen benachbarten Isolationsgräben so gewählt, daß er im wesentlichen gleich der Breite der Isolationsgräben ist. In den Speicherzellen erstreckt sich das Loch in diesem Fall vorzugsweise jeweils über die Breite des Isolationsgrabens. Je zwei Speicherzellen sind an gegenüber liegenden Flanken eines Grabens angeordnet und weisen ein gemeinsames Loch auf, dessen Breite in Richtung senkrecht zum Verlauf der Isolationsgräben der Breite der Gräben entspricht. Die Speicherzellenfläche erstreckt sich senkrecht zum Verlauf der Isolationsgräben jeweils von der Mitte des Isolationsgrabens bis zur Mitte des Abstands zum benachbarten Isolationsgraben. Wird die Breite der Isolationsgräben entsprechend der minimalen Strukturbreite F in der jeweiligen Technologie gewählt und die Breite der Wortleitungen und Abstand der Wortleitungen ebenfalls entsprechend der minimalen Strukturbreite F in der jeweiligen Technologie gewählt, so ergibt sich für die Speicherzelle ein Platzbedarf von 2 F². Legt man eine minimale Strukturbreite von F = 0,4 µm zugrunde, so wird in der Festwertspeicherzelleanordnung eine Speicherdichte von etwa 3,1 Bit/µm² erzielt.

Zur Herstellung der erfindungsgemäßen Festwertspeicherzellenanordnung wird vorzugsweise zunächst an der Hauptfläche des Halbleitersubstrats im Bereich des Zellenfeldes ein dotiertes Gebiet erzeugt. Anschließend wird vorzugsweise eine Ätzstopschicht (Polysilizium oder Nitrid) aufgebracht. Dann werden unter Verwendung einer Grabenmaske Gräben geätzt, wobei die streifenförmigen, dotierten Gebiete zwischen benachbarten Isolationsgräben an der Hauptfläche durch Strukturierung des dotierten Gebietes entstehen. Durch Ionenimplantation werden die am Boden der Gräben angeordneten streifenförmigen dotierten Gebiete gebildet. Dabei ist die Hauptfläche zwischen benachbarten Gräben durch die Grabenmaske geschützt. Um eine zusätzliche Dotierung der Seitenwände der Gräben durch gestreute Ionen zu vermeiden, ist es vorteilhaft, vor der Ionenimplantation die Seitenwände der Gräben mit Spacern, zum Beispiel aus SiO₂, zu versehen.

Nach der Implantation zur Bildung der streifenförmigen, dotierten Gebiete am Boden der Gräben werden die Gräben mit isolierendem Material, zum Beispiel SiO₂, aufgefüllt.

Nach Auffüllen der Gräben erfolgt die Herstellung der Speicherzellen. Dazu wird eine Photolackmaske erzeugt, die die Hauptfläche des Halbleitersubstrats nur an den Stellen unbedeckt läßt, an denen ein Loch für ein Speicherzellenpaar entstehen soll. In einem anisotropen Trockenätzprozeß werden die Löcher an der Flanke der Isolationsgräben geätzt. Dabei wird an der Flanke die Halbleiteroberfläche freigelegt. Das Loch erstreckt sich in den Isolationsgraben hinein. Parallel zum Isolationsgraben ist das Loch vorzugsweise entsprechend der Breite der Wortleitungen begrenzt. Das Loch reicht bis auf die Oberfläche des streifenförmigen dotierten Gebietes am Boden des Isolationsgrabens. Die Halbleiteroberfläche im Loch wird mit einem Gatedielektrikum aus einem Material mit Haftstellen versehen. Anschließend wird das Loch mit einer Gateelektrode aufgefüllt.

Es liegt im Rahmen der Erfindung, unter der Grabenmaske eine Ätzstopschicht vorzusehen, die vor der Grabenätzung entsprechend der Grabenmaske strukturiert wird. Die Ätzstopschicht wird aus einem solchen Material erzeugt, daß das isolierende Material der Isolationsgräben selektiv zur Ätzstopschicht ätzbar ist. Die strukturierte Ätzstopschicht wirkt bei der Lochätzung gemeinsam mit der Photolackmaske als Ätzmaske. Weiter gilt es als vorteilhaft, daß bei der Lochätzung mit Hilfe der Ätzstopschicht das darunterliegende hochdotierte Gebiet nicht abgetragen wird. Daher kann die Breite der Isolationsgräben entsprechend der minimalen Strukturbreite F eingestellt werden. Die Photolackmaske weist streifenförmige Strukturen auf, die quer zu den Isolationsgräben verlaufen. Die Breite der Strukturen in der Photolackmaske entspricht ebenfalls der minimalen Strukturbreite F. Die Justierung der Photolackmaske in Bezug auf die Isolationsgräben somit unkritisch. Bei der Bildung der Löcher wirken die Ätzstopschicht und die Photolackmaske gemeinsam als Ätzmaske.

Im folgenden wird die Erfindung anhand eines Ausführungsbeispiels und der Figuren näher erläutert.
- Figur 1: zeigt ein Substrat mit einem dotierten Gebiet im Zellenfeld.
- Figur 2: zeigt das Substrat mit einer Grabenmaske nach der Ätzung von Gräben.
- Figur 3: zeigt das Substrat nach Bildung von streifenförmigen, dotierten Gebieten am Boden der Gräben.
- Figur 4: zeigt das Substrat nach dem Auffüllen der Gräben mit isolierendem Material und Bildung einer Photolackmaske.
- Figur 5: zeigt das Substrat nach einer Lochätzung, bei der eine Photolackmaske mit streifenförmigen Öffnungen und ein strukturierte Ätzstopschicht gemeinsam als Maske wirken.
- Figur 6: zeigt eine Aufsicht auf Figur 5. In Figur 6 sind mit V-V bzw. VII-VII die in Figur 5 bzw. Figur 7 dargestellten Schnitte bezeichnet.
- Figur 7: zeigt den in Figur 6 mit VII-VII bezeichneten Schnitt durch das Substrat.
- Figur 8: zeigt das Substrat nach Bildung eines Gatedielektrikums, Erzeugung einer dotierten Polysiliziumschicht und nach Strukturierung der dotierten Polysiliziumschicht in Wortleitungen.
- Figur 9: zeigt eine Aufsicht auf ein Zellenfeld einer erfindungsgemäßen Speicherzellenanordnung.

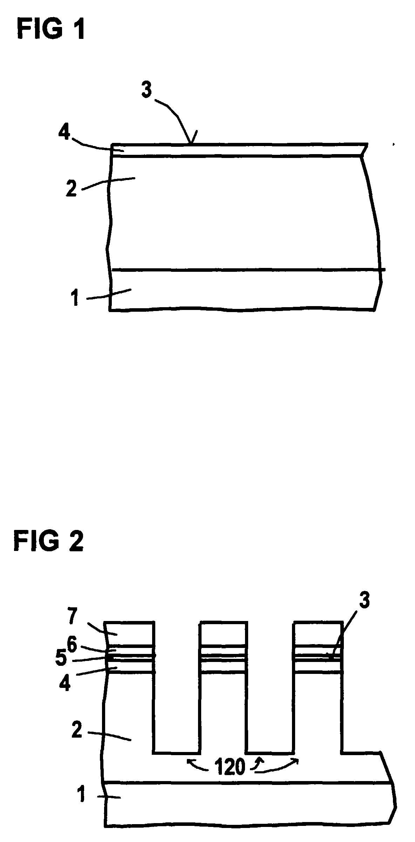

In einem Substrat 1 aus zum Beispiel p-dotiertem monokristallinem Silizium mit einer Dotierstoffkonzentration von 5 x 10¹⁵ cm⁻³ wird eine p-dotierte Wanne 2 mit einer Dotierstoffkonzentration von 2 x 10¹⁷ cm⁻³ durch Implantation und anschließendes Tempern erzeugt (siehe Figur 1). In einem CVD-TEOS Verfahren wird ein Streuoxid von 20 nm ganzflächig abgeschieden (nicht dargestellt). Anschließend wird auf einer Hauptfläche 3 des Substrats 1 eine Photolackmaske (nicht dargestellt) erzeugt, die einen Bereich für ein Zellenfeld und eine Peripherie definiert. Die Photolackmaske bedeckt den Bereich für die Peripherie während die Hauptfläche 3 im Bereich für das Zellenfeld freiliegt.

Durch Implantation mit 50 keV, 5 x 10¹⁵ cm⁻² wird ein n⁺-dotiertes Gebiet 4 erzeugt, das eine Dotierstoffkonzentration von 1 x 10²¹ cm⁻³ aufweist und das sich an der Hauptfläche 3 über den Bereich für das Zellenfeld erstreckt.

Die Photolackmaske wird entfernt und es folgt ein Temperschritt zum Aktivieren der Dotierstoffe. Das n⁺-dotierte Gebiet 4 weist eine Tiefe von etwa 200 nm auf. Die p-dotierte Wanne 2 weist eine Tiefe von 2 µm auf.

Das Streuoxid wird naßchemisch entfernt und es wird ganzflächig eine SiO₂-Schicht 5 in einer Dicke von zum Beispiel 60 nm durch thermische Oxidation erzeugt. Die Oxidation wird beispielsweise bei 800° ausgeführt, da bei niedriger Oxidationstemperatur das hochdotierte n⁺-Gebiet 4 stärker oxidiert als ein schwach dotiertes Gebiet. Auf die SiO₂-Schicht 5 wird eine Ätzstopschicht 6 aufgebracht, die zum Beispiel aus Si₃N₄ oder Polysilizium in einem CVD-Verfahren abgeschieden wird. Die Ätzstopschicht 6 wird in einer Dicke von zum Beispiel 100 nm erzeugt.

Anschließend wird zur Bildung einer Grabenmaske 7 in einem TEOS-Verfahren eine 300 nm dicke SiO₂-Schicht abgeschieden und mit Hilfe photolithographischer Verfahren durch anisotropes Trockenätzen zum Beispiel mit CHF₃, O₂ strukturiert (siehe Figur 2).

Durch anisotropes Trockenätzen werden anschließend die Ätzstopschicht 6 und die SiO₂-Schicht 5 entsprechend der Grabenmaske 7 strukturiert. Das Ätzen der Ätzstopschicht 6 erfolgt mit CHF₃, O₂, falls diese aus Si₃N₄ besteht, und mit HBr, Cl₂ falls diese aus Polysilizium besteht. Die SiO₂-Schicht 5 wird mit CHF₃, O₂ geätzt. Nach Entfernen einer Photolackmaske, die zur Strukturierung der Grabenmaske 7 aufgebracht wurde, wird eine Grabenätzung durchgeführt. Die Grabenätzung erfolgt in einem anisotropen Trockenätzprozeß mit zum Beispiel HBr, He, O₂, NF₃. Dabei werden Gräben 120 erzeugt, die eine Tiefe von zum Beispiel 0,6 µm aufweisen. Die Gräben 120 erstrecken sich über einen Block des Zellenfeldes. Sie weisen eine Länge von zum Beispiel 250 µm und eine Breite von zum Beispiel 0,4 µm auf. Im Zellenfeld sind benachbarte Gräben 120 in einem Abstand von 0,4 µm angeordnet. Die Gräben 120 verlaufen im wesentlichen parallel. Im Block des Zellenfeldes 5 werden zum Beispiel 64 parallele Gräben erzeugt.

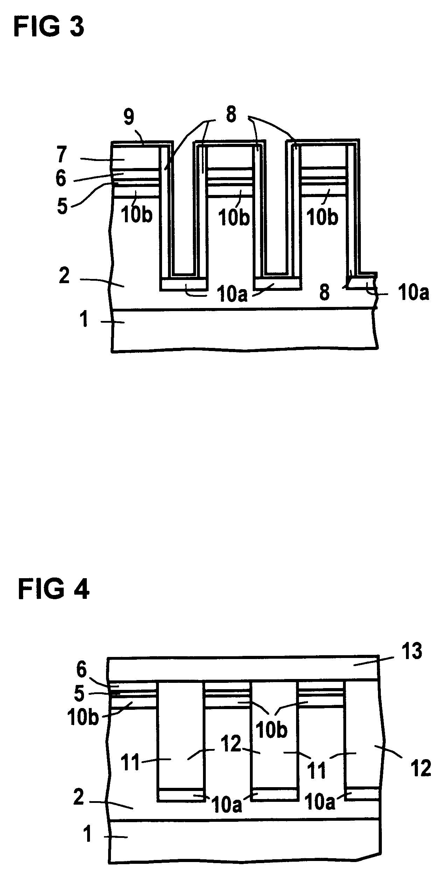

Durch konforme Abscheidung einer TEOS-SiO₂-Schicht in einer Dicke von 60 nm und anschließendes anisotropes Trockenätzen mit CHF₃, O₂ werden an senkrechten Flanken, insbesondere der Gräben 120 und der Grabenmaske 7 SiO₂-Spacer 8 erzeugt (siehe Figur 3).

Anschließend wird ganzflächig in einem TEOS-Verfahren eine Streuoxidschicht 9 in einer Dicke von 20 nm abgeschieden. Es wird eine Photolackmaske (nicht dargestellt) erzeugt, die die Peripherie abdeckt und das Zellenfeld unbedeckt läßt. Es wird eine Ionenimplantation durchgeführt, bei der am Boden der Gräben 120 n⁺-dotierte, streifenförmige Gebiete 10a gebildet werden. Die Photolackmaske wird gestrippt und die dotierten Gebiete 10a werden durch einen Temperschritt aktiviert. In den streifenförmigen, dotierten Gebieten 10a wird eine Dotierstoffkonzentration von zum Beispiel 10²¹ cm⁻³ eingestellt. An der Hauptfläche 3 des Halbleitersubstrats 1 sind zwischen benachbarten Gräben 120 bei der Grabenätzung streifenförmige, dotierte Gebiete 10b durch Strukturierung des n⁺-dotierten Gebietes 4 entstanden.

Anschließend wird die Grabenmaske 7 entfernt. Die Entfernung der Grabenmaske 7 erfolgt zum Beispiel mit HF-Dampf (Excalibur-Anlage) oder in einem HF-Dip. Beim Entfernen der Grabenmaske 7 wird auch die Streuoxidschicht 9 und die SiO₂-Spacer 8 entfernt. Dabei werden in den Gräben 120 die Oberflächen der p-dotierten Wanne 2 freigelegt. Um die Qualität dieser Kristalloberflächen zu verbessern, wird durch thermische Oxidation eine SiO₂-Schicht in einer Dicke von 20 nm erzeugt. Diese SiO₂-Schicht ist in den Figuren der Übersichtlichkeit halber nicht dargestellt.

Anschließend werden die Gräben 120 durch Abscheidung einer TEOS-SiO₂-Schicht in einer Dicke von zum Beispiel 800 nm aufgefüllt. Durch Rückätzen mit CHF₃, O₂ werden die Anteile der TEOS-SiO₂-Schicht oberhalb der Hauptfläche 3 entfernt. Das Rückätzen stoppt auf der Ätzstopschicht 6. In diesem Prozeßschritt sind die Gräben 120 mit einer Grabenfüllung 11 aus SiO₂ versehen worden. Die Gräben 120 und die Grabenfüllung 11 bilden zusammen Isolationsgräben 12 (siehe Figur 4). In einem Temperschritt bei zum Beispiel 900°C während zum Beispiel 10 min wird die Grabenfüllung 11 verdichtet. Dadurch verändern sich die Ätzeigenschaften des SiO₂.

Es wird eine Photolackmaske 13 erzeugt, die das Zellenfeld abdeckt. Unter Verwendung der Photolackmaske 13 als Ätzmaske wird die Ätzstopschicht 6 im Bereich der Peripherie und im Bereich der Kontakte zu den Bitleitungen am Rand des Zellenfeldes entfernt. Die Photolackmaske 13 wird gestrippt.

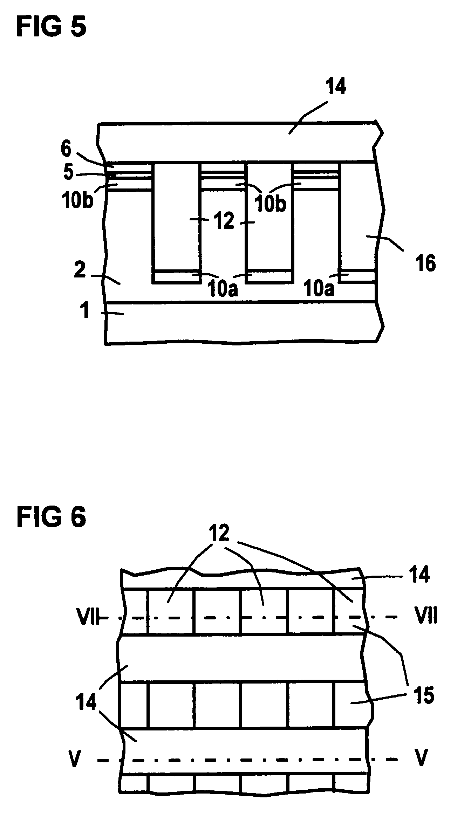

Es wird ganzflächig eine Photolackmaske 14 erzeugt (siehe Figur 5 und Aufsicht in Figur 6). Die Photolackmaske 14 weist streifenförmige Öffnungen 15 auf, die quer zu den Isolationsgräben 12 verlaufen. Die Öffnungen 15 der Photolackmaske 14 weisen einen im wesentlichen rechteckigen Querschnitt parallel zur Hauptfläche 3 auf mit einer Breite von einer minimalen Strukturbreite zum Beispiel F = 0,4 µm, einer Länge entsprechend der Ausdehnung des Zellenfeldes und einem Abstand zwischen benachbarten Öffnungen 15 von einer minimalen Strukturbreite zum Beispiel F = 0,4 µm. Die Peripherie wird von der Photolackmaske 14 abgedeckt.

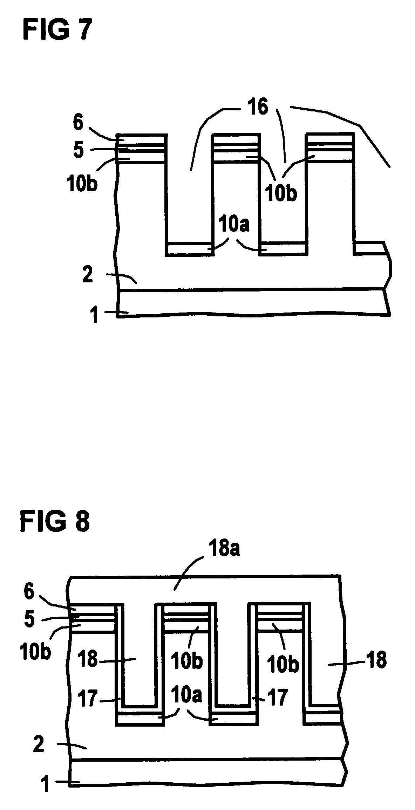

In einem anisotropen Trockenätzprozeß, der selektiv zur Ätzstopschicht 6 die Grabenfüllung 11 angreift, werden Löcher 16 in die Isolationsgräben 12 geätzt. Besteht die Ätzstopschicht 6 aus Si₃N₄, so erfolgt die Ätzung mit C₂F₆, C₃F₈. Besteht die Ätzstopschicht 6 aus Polysilizium, so erfolgt die Ätzung mit HBr, Cl₂, He. Die Ätzung wird fortgesetzt, bis 700 nm SiO₂ entfernt sind. Die Löcher 16 reichen dann bis auf die Oberfläche des streifenförmigen, dotierten Gebietes 10a, das am Boden des jeweiligen Isolationsgrabens 12 angeordnet ist. Da die strukturierte Ätzstopschicht 6 und die Photolackmaske 14 gemeinsam als Ätzmaske wirken, sind die Abmessungen des Lochs 16 senkrecht zum Verlauf der Isolationsgräben 12 durch die Breite der Isolationsgräben 12 und senkrecht zum Verlauf der streifenförmigen Öffnungen 15 durch die Breite der streifenförmigen Öffnungen 15 gegeben. Die Justierung der Photolackmaske 14 ist dabei unkritisch. An beiden Seitenwänden und am Boden des Loches 15 ist die Halbleiteroberfläche freigelegt (siehe Figur 7).

Anschließend wird die Photolackmaske 14 entfernt. In einem HF-Dip werden Ätzprodukte, die sich an den Wänden der Löcher 16 beim anisotropen Ätzen niedergeschlagen haben, entfernt. Zur Verbesserung der Halbleiteroberfläche wird anschließend ein thermisches sacrificial Oxid zum Beispiel von 10 nm erzeugt und anschließend naßchemisch entfernt.

Auf freiliegenden Halbleiteroberflächen in den Löchern 16 wird ein Gatedielektrikum 17 erzeugt (siehe Figur 8). Das Gatedielektrikum 17 wird aus einem Material mit hoher Haftstellendichte für in das Dielektrikum injizierte Ladungsträger gebildet.

Das Gatedielektrikum 17 wird zum Beispiel aus einer dielektrischen Mehrfachschicht gebildet, in der mindestens eine Schicht vorgesehen ist, die im Vergleich mit mindestens einer weiteren Schicht in der Mehrfachschicht einen erhöhten Ladungsträgereinfangquerschnitt aufweist. Vorzugsweise umfaßt die dielektrische Mehrfachschicht eine SiO₂-Schicht, eine Si₃N₄-Schicht und eine SiO₂-Schicht (sogenanntes ONO). Die Schichtdicken in der Mehrfachschicht werden so bemessen, daß die Mehrfachschicht bezüglich ihrer Kapazität einer Schicht aus thermischem SiO₂ mit einer Dicke von zum Beispiel 10 nm entspricht. Dazu sind für die SiO₂- Schichten Schichtdicken jeweils von 4 nm und für die Si₃N₄-Schicht eine Schichtdicke von 5 nm erforderlich.

Alternativ kann das Gatedielektrikum 17 als Mehrfachschicht aus anderen Materialien, wobei die Schicht mit dem erhöhten Ladungsträgereinfangquerschnitt zum Beispiel aus Si₃N₄, Ta₂O₅, Al₂O₃ oder aus TiO₂ besteht und die benachbarte Schicht aus SiO₂, Si₃N₄ oder Al₂O₃. Ferner kann das Gatedielektrikum 17 eine dielektrische Schicht, zum Beispiel aus SiO₂ umfassen, in die Fremdatome , zum Beispiel W, Pt, Cr, Ni, Pd, Si oder Ir eingelagert sind. Die eingelagerten Fremdatome können durch Implantation, durch Zugabe bei einer Oxidation oder durch Diffusion eingebracht werden.

Anschließend wird eine dotierte Polysiliziumschicht 18 in einer Dicke von 400 nm erzeugt. Die dotierte Polysiliziumschicht 18 wird zum Beispiel undotiert abgeschieden und durch Implantation oder Diffusion, zum Beispiel nach POCl-Belegung, n-dotiert. Alternativ wird die dotierte Polysiliziumschicht 18 durch insitu-dotierte Abscheidung erzeugt. Die dotierte Polysiliziumschicht 18 füllt die Löcher 16 vollständig aus.

Mit Hilfe photolithographischer Verfahren wird die dotierte Polysiliziumschicht 18 so strukturiert, daß im Bereich des Zellenfeldes Wortleitungen 18a entstehen (siehe Figur 8). Der in den Löchern 16 angeordnete Teil der dotierten Polysiliziumschicht 18 wirkt als Gateelektrode für vertikale Transistoren, die aus den dotierten streifenförmigen Gebieten 10a, 10b, die an das jeweilige Loch 16 angrenzen, den dazwischen angeordneten Teil der p-dotierten Wanne 2 und das Gatedielektrikum 17 gebildet werden. Die Schwellenspannung vor der elektrischen Programmierung durch Injektion von Elektronen in das Gatedielektrikum 17 dieser vertikalen MOS-Transistoren ist über die Dotierung der p-dotierten Wanne 2 vorgegeben.

Die Wortleitungen 18a verlaufen im wesentlichen senkrecht zu den Isolationsgräben 12. Sie weisen eine Breite von einer minimalen Strukturbreite F auf und sind im Abstand von zum Beispiel F = 0,4 µm angeordnet. Durch den Abstand benachbarter Wortleitungen 18a sind entlang einer Flanke eines Isolationsgrabens 12 benachbarte Speicherzellen gegeneinander isoliert. Im Bereich des Zellenfeldes sind zum Beispiel 64 Wortleitungen 18a parallel nebeneinander angeordnet. Die Gateelektroden der vertikalen MOS-Transistoren sind herstellungsbedingt mit der jeweiligen Wortleitung 18a verbunden.

Zur Fertigstellung der Speicherzellenanordnung wird nach Herstellung von lateralen Transistoren in der Peripherie, die zur Ansteuerung der Speicherzellenanordnung eingesetzt werden, ganzflächig eine planarisierende Zwischenoxidschicht zum Beispiel aus Bor-Phosphor-Silikat-Glas abgeschieden, in der Kontaktlöcher geöffnet werden. Kontaktlöcher werden unter anderem zu den Wortleitungen 18a, zu den streifenförmigen dotierten Gebieten 10a, die am Boden der Isolationsgräben 12 angeordnet sind und zu den streifenförmigen, dotierten Gebieten 10b, die an der Hauptfläche 3 zu den benachbarten Isolationsgräben 12 angeordnet sind, geöffnet. Die Kontaktlöcher werden zum Beispiel mit Wolfram aufgefüllt. Es folgt die Erzeugung einer Metallisierungsebene zum Beispiel durch Abscheidung und Strukturierung einer Aluminiumschicht. Schließlich wird eine Passivierungsschicht aufgebracht. Diese Standardschritte sind nicht im einzelnen dargestellt.

Zur Programmierung der vertikalen MOS-Transistoren werden Elektronen in das Gatedielektrikum 17 injiziert. Dies erfolgt zum Beispiel mit heißen Elektronen, die unter bestimmten Spannungsbedingungen im entsprechenden Transistor selbst erzeugt werden. Die Elektronen werden in den Haftstellen im Gatedielektrikum 17 eingefangen und verschieben so die Einsatzspannung des vertikalen MOS-Transistors. Auf diese Weise werden die Einsatzspannungen der vertikalen MOS-Transistoren je nach gespeicherter digitaler Information auf zwei verschiedene Werte eingestellt.

In der erfindungsgemäß hergestellten Speicherzellenanordnung erfolgt die Bewertung der Speicherzelle nach dem 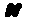 virtual ground"-Prinzip. Jedes der streifenförmigen, dotierten Gebiete 10a, 10b ist zwei Reihen von Speicherzellen zugeordnet. Ein Paar der streifenförmigen, dotierten Gebiete 10a, 10b, das aus benachbart angeordneten dotierten Gebieten an der Hauptfläche 10a und am Boden 10b zusammengesetzt ist, ist dabei eindeutig einer Reihe Speicherzellen zugeordnet. Beim Auslesen der Festwertspeicherzellenanordnung wird daher nach Auswahl über die Wortleitung 18a der Stromfluß zwischen einem streifenförmigen dotierten Gebiet 10a am Boden eines Isolationsgrabens und einem benachbarten streifenförmigen dotierten Gebiet 10b an der Hauptfläche 3 bewertet. Die streifenförmigen, dotierten Gebiete 10a, 10b am Boden der Isolationsgräben und an der Hauptfläche 3 wirken je nach Beschaltung als Referenz- oder Bitleitung.

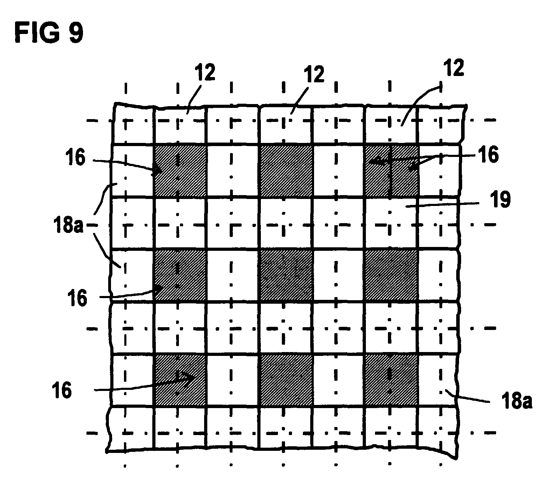

Figur 9 zeigt eine Aufsicht auf das Zellenfeld der erfindungsgemäßen Speicherzellenanordnung. Die Speicherzellenanordnung umfaßt im Zellenfeld Speicherzellen 19. Die Zellengröße der Speicherzellen 19 ist in Figur 9 als strichpunktierte Linie eingetragen. Der Flächenbedarf einer Speicherzelle 19 beträgt in diesem Ausführungsbeispiel 2F², wobei F die in der jeweiligen Lithographie kleinste herstellbare Strukturgröße ist.

## Patentansprüche

1. Elektrisch programmierbare Speicherzellenanordnung,
- bei der an einer Hauptfläche (3) eines Halbleitersubstrats (1) ein Zellenfeld mit Speicherzellen (19) vorgesehen ist,
- bei der die Speicherzellen (19) mindestens einen zur Hauptfläche (3) vertikalen MOS-Transistor mit einem Gatedielektrikum (17) aus einem Material mit Haftstellen umfassen.

2. Speicherzellenanordnung nach Anspruch 1,
- bei der das Halbleitersubstrat (1) mindestens im Bereich des Zellenfeldes von einem ersten Leitfähigkeitstyp dotiert ist,
- bei der im Zellenfeld mehrere, im wesentlichen parallel verlaufende streifenförmige Isolationsgräben (12) vorgesehen sind,
- bei der am Boden der Isolationsgräben (12) und an der Hauptfläche (3) zwischen benachbarten Isolationsgräben (12) jeweils streifenförmige, dotierte Gebiete (10a, 10b) angeordnet sind, die von einem zweiten, vom ersten entgegengesetzten Leitfähigkeitstyp dotiert sind und die im wesentlichen parallel zu den Isolationsgräben (12) verlaufen,
- bei der die Speicherzellen (19) jeweils an gegenüberliegenden Flanken der Isolationsgräben (12) angeordnet sind,
- bei der Wortleitungen (18a) vorgesehen sind, die quer zu den Isolationsgräben (12) verlaufen und die jeweils mit Gateelektroden von vertikalen MOS-Transistoren verbunden sind, die unterhalb der jeweiligen Wortleitung (18a) angeordnet sind,
- bei der die Speicherzellen (19) jeweils ein Loch (16) umfassen, das sich von einer Flanke eines der Isolationsgräben (12) in den Isolationsgraben (12) hinein erstreckt, dessen Oberfläche mit dem Gatedielektrikum (17) versehen ist und das mit einer Gateelektrode (18) aufgefüllt ist, so daß die an die Flanke angrenzenden, streifenförmigen dotierten Gebiete (10a, 10b) die Source/Drain-Gebiete des vertikalen MOS-Transistors bilden.

3. Speicherzellenanordnung nach Anspruch 2,
- bei der der Abstand zwischen benachbarten Isolationsgräben (12) im wesentlichen gleich der Breite der Isolationsgräben (12) ist,
- bei der je zwei an gegenüberliegenden Flanken eines Isolationsgrabens (12) angeordnete Speicherzellen (19) ein gemeinsames Loch (16) aufweisen, das sich über die gesamte Breite des Isolationsgrabens (12) erstreckt.

4. Speicherzellenanordnung nach einem der Ansprüche 1 bis 3, bei der die MOS-Transistoren als Gatedielektrikum (17) eine dielektrische Mehrfachschicht umfassen mit mindestens einer Schicht, die im Vergleich mit mindestens einer weiteren Schicht einen erhöhten Ladungsträgereinfangsquerschnitt aufweist.

5. Speicherzellenanordnung nach Anspruch 4,
- bei der die Schicht mit erhöhtem Ladungsträgereinfangsquerschnitt mindestens einen der Stoffe Si₃N₄, Ta₂O₅, Al₂O₃ oder TiO₂ umfaßt,
- bei der die weitere Schicht mindestens einen der Stoffe SiO₂, Si₃N₄ oder Al₂O₃ umfaßt.

6. Speicherzellenanordnung nach einem der Ansprüche 1 bis 3, bei der die MOS-Transistoren als Gatedielektrikum (17) eine dielektrische Schicht mit eingelagerten Fremdatomen umfassen, wobei die eingelagerten Fremdatome im Vergleich mit der dielektrischen Schicht einen erhöhten Ladungsträgereinfangsquerschnitt aufweisen.

7. Speicherzellenanordnung nach Anspruch 6,
- bei der die dielektrische Schicht SiO₂ umfaßt,
- bei der die eingelagerten Fremdatome mindestens eines der Elemente W, Pt, Cr, Ni, Pd, Si oder Ir enthalten.

8. Verfahren zur Herstellung einer Speicherzellenanordnung,
- bei dem an einer Hauptfläche (3) eines Halbleitersubstrats (1) ein Zellenfeld mit Speicherzellen (19), die mindestens einen zur Hauptfläche (3) vertikalen MOS-Transistor mit einem Gatedielektrikum (17) aus einem Material mit Haftstellen umfassen, gebildet wird.

9. Verfahren nach Anspruch 8,
- bei dem das Halbleitersubstrat (1) mindestens im Bereich des Zellenfeldes von einem ersten Leitfähigkeitstyp dotiert ist,
- bei dem mehrere im wesentlichen parallel verlaufende, streifenförmige Isolationsgräben (12) erzeugt werden,
- bei dem am Boden der Isolationsgräben (12) und an der Hauptfläche (3) zwischen benachbarten Isolationsgräben (12) jeweils streifenförmige, dotierte Gebiete (10a, 10b) gebildet werden, die von einem zweiten, zum ersten entgegengesetzten Leitfähigkeitstyp dotiert sind,
- bei dem die Speicherzellen jeweils an gegenüberliegenden Flanken der Isolationsgräben (12) gebildet werden, wobei entlang einer Flanke benachbarte Speicherzellen gegeneinander isoliert werden,
- bei dem zur Bildung vertikaler Transistoren Löcher (16) geöffnet werden, die jeweils an eine Flanke eines der Isolationsgräben (12) angrenzen und bis auf das am Boden des Isolationsgrabens (12) verlaufende dotierte Gebiet (10a) reichen und deren Oberfläche mit dem Gatedielektrikum (17) und einer Gateelektrode (18) versehen wird.

10. Verfahren nach Anspruch 9,
- bei dem zur Bildung der Isolationsgräben (12) und der streifenförmigen dotierten Gebiete (10a, 10b) an der Hauptfläche des Halbleitersubstrats (1) ein vom zweiten Leitfähigkeitstyp dotiertes Gebiet (4) erzeugt wird, das sich über das gesamte Zellenfeld erstreckt,
- bei dem eine Grabenmaske (7) erzeugt wird, die die Anordnung der Isolationsgräben (12) definiert,
- bei dem in einem anisotropen Trockenätzprozeß unter Verwendung der Grabenmaske (7) als Ätzmaske Gräben (120) geätzt werden, wobei die an der Hauptfläche (3) zwischen benachbarten Isolationsgräben (12) angeordneten, streifenförmigen dotierten Gebiete (10b) durch Strukturierung des vom zweiten Leitfähigkeitstyp dotierten Gebietes (4) gebildet werden,
- bei dem die am Boden der Gräben angeordneten streifenförmigen dotierten Gebiete (10a) durch Ionenimplantation gebildet werden, wobei die Grabenmaske (7) als Implantationsmaske wirkt,
- bei dem nach Entfernen der Grabenmaske (7) die Isolationsgräben (12) durch Auffüllen der Gräben (120) mit isolierendem Material (11) fertiggestellt werden.

11. Verfahren nach Anspruch 10,
bei dem vor der Ionenimplantation zur Bildung der am Boden der Gräben angeordneten streifenförmigen dotierten Gebiete (10a) die Seitenwände der Gräben mit maskierenden Spacern (8) bedeckt werden, die vor dem Auffüllen der Gräben entfernt werden.

12. Verfahren nach Anspruch 10 oder 11,
- bei dem unter der Grabenmaske (7) eine Ätzstopschicht (6) erzeugt wird, zu der das isolierende Material der Isolationsgräben (12) selektiv ätzbar ist,
- bei dem die Ätzstopschicht vor der Grabenätzung entsprechend der Grabenmaske (7) strukturiert wird,
- bei dem nach Fertigstellung der Isolationsgräben (12) eine Photolackmaske (14) erzeugt wird, die streifenförmige Öffnungen, die quer zu den Isolationsgräben (12) verlaufen, aufweist,
- bei dem in einem anisotropen Trockenätzprozeß, bei dem die Photolackmaske (14) und die strukturierte Ätzstopschicht (6) gemeinsam als Ätzmaske wirken, die Löcher (16) für die vertikalen MOS-Transistoren geöffnet werden.

13. Verfahren nach Anspruch 12,
- bei dem die Isolationsgräben (12) mit SiO₂ gefüllt werden,
- bei dem die Ätzstopschicht (6) mindestens eines der Materialien Si₃N₄, amorphes Silizium und Polysilizium enthält,
- bei dem das Halbleitersubstrat (1) mindestens im Bereich des Zellenfeldes monokristallines Silizium umfaßt.

14. Verfahren nach einem der Ansprüche 8 bis 13,
bei dem das Gatedielektrikum (17) als Mehrfachschicht mit mindestens einer Schicht, die im Vergleich mit mindestens einer weiteren Schicht einen erhöhten Ladungsträgereinfangsquerschnitt aufweist, gebildet wird.

15. Verfahren nach Anspruch 14,
- bei dem die Schicht mit erhöhtem Ladungsträgereinfangsquerschnitt mindestens einen der Stoffe Si₃N₄, Ta₂O₅, Al₂O₃ oder TiO₂ umfaßt,
- bei dem die weitere Schicht mindestens einen der Stoffe SiO₂, Si₃N₄ oder Al₂O₃ umfaßt

16. Verfahren nach einem der Ansprüche 8 bis 13,
bei dem das Gatedielektrikum (17) als dielektrische Schicht mit eingelagerten Fremdatomen gebildet wird, wobei die eingelagerten Fremdatome im Vergleich mit der dielektrischen Schicht einen erhöhten Ladungsträgereinfangsquerschnitt aufweisen.

17. Verfahren nach Anspruch 16,
- bei dem die dielektrische Schicht SiO₂ umfaßt,
- bei dem die eingelagerten Fremdatome mindestens eines der Elemente W, Pt, Cr, Ni, Pd, Si oder Ir enthalten.
